# EUROPEAN PATENT APPLICATION

(11) **EP 4 836 614 A1**
(43) Date of publication of application: **04.11.2026**
(21) Application number: 24917338.6
(22) Date of filing: 24.12.2024
(51) Int. Cl.: H05K 7/20, H01L 23/367, H01L 23/427

(54) **HEAT DISSIPATION STRUCTURE AND ELECTRONIC DEVICE COMPRISING SAME**

(30) Priority: 13.01.2024 KR 20240005741; 17.01.2024 KR 20240007675
(71) Applicant: Samsung Electronics Co., Ltd., Suwon-si, Gyeonggi-do 16677 (KR)
(72) Inventor: YU, Sangsoo, Suwon-si Gyeonggi-do 16677 (KR)
(74) Representative: Gulde & Partner
(86) International application number: PCT/KR2024/021064
(87) International publication number: WO 2025/150744

(57) **Abstract**

In embodiments, an electronic device is provided. The electronic device may comprise: a printed circuit board; an electronic component arranged on one surface of the printed circuit board; and a housing for dissipating heat of the electronic component. The housing may include a base portion for the electronic component, a cover portion arranged on a support of the base portion, and a plurality of fin portions coupled to the cover portion. Each of the plurality of fin portions may have a heat dissipation plate region and protruding regions. A portion of the heat dissipation plate region may protrude from a first surface of the cover portion, and another portion of the heat dissipation plate region may protrude from a second surface of the cover portion, which is opposite to the first surface. The protruding regions may be coupled to the support or the cover portion such that the heat dissipation plate region is spaced apart from one surface of the base portion by a predetermined distance or more.

## Description

### Technical Field

The present disclosure relates to a heat dissipation structure and an electronic device including the same.

### Background Art

An electronic device may include various electronic parts to perform communication. Electronic parts in the electronic device may generate heat. For example, heat generated in an electronic part may degrade performance of the electronic part and another electronic part. In order to dissipate the heat generated in the electronic part, the electronic device may include a heat dissipation structure.

The above-described information may be provided as a related art for the purpose of helping understanding of the present disclosure. No argument or decision is made as to whether any of the above description may be applied as a prior art related to the present disclosure.

### Disclosure

### Technical Solution

In embodiments, an electronic device is provided. The electronic device may comprise a printed circuit board, an electronic part disposed on a side of the PCB, and a housing for heat dissipation of the electronic part. The housing may include a base portion for the electronic part, a cover portion disposed on a support of the base portion, and a plurality of fin portions coupled to the cover portion. Each of the plurality of fin portions may have a heat sink area and protruding areas. A portion of the heat sink area may be disposed to protrude from a first side of the cover portion, and another portion of the heat sink area may be disposed to protrude from a second side of the cover portion opposite to the first side. The protruding areas may be coupled to the support or the cover portion such that the heat sink area is disposed to be spaced apart from one side of the base portion by a predetermined distance or more.

In embodiments, a housing having a vapor chamber is provided. The housing may comprise a base portion having a support, a cover portion disposed on the support of the base portion, and a plurality of fin portions coupled to the cover portion. Each of the plurality of fin portions may have a heat sink area and protruding areas. A portion of the heat sink area may be disposed to protrude from a first side of the cover portion, and another portion of the heat sink area may be disposed to protrude from a second side of the cover portion opposite to the first side. The protruding areas may be coupled to the support or the cover portion such that the heat sink area is disposed to be spaced apart from one side of the base portion by a predetermined distance or more.

### Description of the Drawings

FIG. 1 illustrates a wireless communication system.
FIG. 2 illustrates network entities according to a distributed deployment.
FIG. 3A illustrates an example of an exterior of an electronic device including a heat dissipation structure.
FIG. 3B illustrates an example of an electronic device including a heat dissipation structure.
FIG. 4 illustrates a front view of a housing having a vapor chamber.
FIG. 5 illustrates a perspective view of a housing having a vapor chamber.
FIG. 6 illustrates an example of components of a housing having a vapor chamber.
FIG. 7A and FIG. 7B illustrate a connection structure between components of a housing having a vapor chamber.
FIG. 8A to FIG. 8D illustrate examples of deployments of a protruding area of a housing for separating a cover portion and a base portion of the housing.
FIG. 9A and FIG. 9B illustrate examples of a fin of a housing having a vapor chamber.
FIG. 10 illustrates an example of a design of pillars of a base portion.
FIG. 11A and FIG. 11B illustrate an example of an electronic device including a housing having a vapor chamber.
FIG. 12A and FIG. 12B illustrate an example of an electronic device including a housing having a vapor chamber.

### Mode for Invention

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example.

However, since the various embodiments of the present disclosure include technology that uses both hardware and software, the various embodiments of the present disclosure do not exclude a software-based approach.

Terms referring to a component of an electronic device (e.g., a communication module, a wireless communication module, a heat dissipation module, a substrate, a printed circuit board (PCB), a flexible PCB (FPCB), a printed circuit board assembly (PBA), a module, an antenna, an antenna element, circuitry, a processor, a chip, a component, and a device), terms referring to RF-related components (e.g., a front end module (FEM), a power amplifier module (PAM), a FEM including duplexer (FEMid), a power amplifier module including duplexer (PAMid), a low noise amplifier PAM including duplexer (LPAMid), a radio frequency front end (RFFE), and a radio frequency integrated circuit (RFIC)), terms referring to shapes of components (e.g., an opening area, an opening portion, a protruding area, a protrusion portion, a structure, a structural body, a support, and a contact), terms referring to connection portions between structures (e.g., a connection portion, a contact, a support, a contact structure, a conductive member, and an assembly), and terms referring to circuitry (e.g., PCB, FPCB, a signal line, a feeding line, a data line, an RF signal line, an antenna line, an RF path, an RF module, an RF circuit, a splitter, a divider, a coupler, and a combiner), used in the following description are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

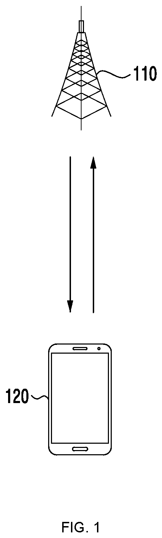

FIG. 1 illustrates a wireless communication system.

Referring to FIG. 1, FIG. 1 illustrates a base station 110 and a terminal 120 as a portion of nodes that utilize a wireless channel in a wireless communication system. FIG. 1 illustrates only one base station, but a wireless communication system may further include another base station that is identical or similar to the base station 110.

The base station 110 is a network infrastructure that provides wireless access to the terminal 120. The base station 110 has coverage defined based on a distance at which a signal may be transmitted. In addition to 'base station', the base station 110 may be referred to as 'access point (AP)', 'radio access network (RAN) node' 'eNodeB (eNB)', '5th generation node', 'next generation nodeB (gNB)', 'wireless point', 'transmission/reception point (TRP)', 'communication node', 'wireless communication device', 'wireless communication equipment', 'network node', 'network entity' or other terms having equivalent technical meanings.

The terminal 120, which is a device used by a user, performs communication with the base station 110 through a wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel. At this time, a link (device-to-device link (D2D)) between the terminal 120 and the other terminal is referred to as a sidelink, and the sidelink may be used interchangeably with a PC5 interface. In some other embodiments, the terminal 120 may be operated without the user's involvement. According to an embodiment, the terminal 120, which is a device performing machine type communication (MTC), may not be carried by the user. Additionally, according to an embodiment, the terminal 120 may be a narrowband (NB)-internet of things (IoT) device.

In addition to 'terminal', the terminal 120 may also be referred to as 'user equipment (UE) ', 'customer premises equipment, (CPE) ', 'mobile station', 'subscriber station', 'remote terminal', 'wireless terminal', 'electronic device', 'user device', or other terms having equivalent technical meanings.

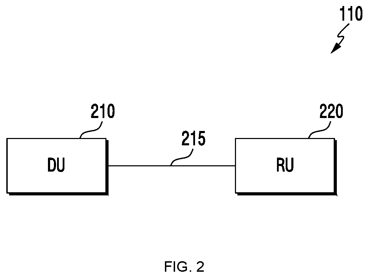

Conventionally, in a communication system having a relatively large cell radius of a base station, each base station was installed to include functions of a digital processing unit (or a distributed unit (DU)) and a radio frequency (RF) processing unit (or a radio unit (RU)). However, as a high frequency band is used in a 4th generation (4G) and/or subsequent communication system (e.g., 5G) and a cell coverage of a base station becomes smaller, the number of base stations for covering a specific area has increased. A burden of an installation cost of an operator for installing the base stations has also increased. In order to minimize the installation cost of the base stations, a structure has been proposed in which a DU and an RU of a base station (e.g., the base station 110) are separated, one or more RUs are connected to one DU through a wired network, and the one or more RUs geographically distributed for covering a specific area are disposed. A description of the distributed arrangement will be described in more detail with reference to FIG. 2.

FIG. 2 illustrates network entities according to a distributed deployment. For example, the network entities may include a digital unit (DU) and a radio unit (RU) 220 (or a massive multiple input multiple output unit (MMU)). For example, the network entities may be connected through a fronthaul. Unlike a backhaul between a base station and a core network, the fronthaul refers to entities (e.g., the DU 210 and the RU 220) between a wireless LAN and the base station. In FIG. 2, The DU 210 illustrates an example of a fronthaul structure between one RU 220, but this is only for convenience of description and the present disclosure is not limited thereto. In other words, an embodiment of the present disclosure may also be applied to a fronthaul structure between one DU and a plurality of RUs. For example, an embodiment of the present disclosure may be applied to a fronthaul structure between one DU and two RUs. In addition, an embodiment of the present disclosure may be applied to a fronthaul structure between one DU and three RUs.

Referring to FIG. 2, a base station 110 may include the DU 210 and the RU 220. A fronthaul 215 between the DU 210 and the RU 220 may be operated through an Fx interface. For operation of the fronthaul 215, for example, an interface such as enhanced common public radio interface (eCPRI) and radio over ethernet (ROE) may be used. According to an implementation example, in addition to the DU, the DU 210 may be referred to as a baseband unit (BBU), a digital BBU, a baseband digital unit, a processing unit, digital processing circuitry, baseband processing circuitry, a baseband processing unit, and/or an equivalent technical term. According to an implementation example, in addition to the RU, the RU 220 may be referred to as a remote unit, a radio demote head (RRH), radio processing circuitry, a radio processing unit, an antenna integrated radio, an air radio device, an air scale communication device, a radio device, a radio communication device, and/or an equivalent technical term. In addition, according to an implementation example, a network entity connected to the DU 210 is described as the RU 210 in the present disclosure, but the massive multiple input multiple output unit (MMU) may be connected to the DU 210 and used instead of the RU 210.

As a communication technology develops, mobile data traffic increases, and accordingly, a bandwidth requirement required in a fronthaul between a digital unit and a radio unit has greatly increased. In a deployment such as a centralized/cloud radio access network (C-RAN), a DU may be implemented to perform functions for a packet data convergence protocol (PDCP), a radio link control (RLC), a media access control (MAC), and a physical (PHY), and an RU may be implemented to further perform functions for the PHY layer in addition to a radio frequency (RF) function. The DU 210 may be responsible for an upper layer function of a wireless network.

For example, the DU 210 may perform a function of the MAC layer and a portion of the PHY layer. Herein, the portion of the PHY layer refers to being performed at a relatively higher stage among the functions of the PHY layer, and, as an example, may include channel encoding (or channel decoding), scrambling (or descrambling), modulation (or demodulation), and layer mapping (or layer demapping). According to an embodiment, in a case that the DU 210 conforms to an O-RAN standard, the DU 210 may be referred to as an O-DU. The DU 210 may be replaced with and represented as a first network entity for a base station (e.g., gNB) in embodiments of the present disclosure as necessary. The RU 220 may be responsible for lower layer functions of the wireless network. For example, the RU 220 may perform a portion of the PHY layer and an RF function. Herein, the portion of the PHY layer refers to being performed at a relatively lower stage than the DU 210 among the functions of the PHY layer, and, as an example, may include iFFT transformation (or FFT transformation), CP insertion (CP removal), and digital beamforming. The RU 220 may be referred to as 'an access unit (AU)', 'an access point (AP)', 'a transmission/reception point (TRP)', 'a remote radio head (RRH)', 'a radio unit (RU)', or another term having an equivalent technical meaning. According to an embodiment, in a case that the RU 220 conforms to the O-RAN standard, the RU 220 may be referred to as an O-RU. The RU 220 may be replaced with and represented as a second network entity for the base station (e.g., gNB) in embodiments of the present disclosure as necessary.

In FIG. 2, the base station 110 is described as including the DU 210 and the RU 220, but embodiments of the present disclosure are not limited thereto. The base station according to embodiments may be implemented as a distributed deployment according to a centralized unit (CU) configured to perform functions of upper layers (e.g., a packet data convergence protocol (PDCP), or a radio resource control (RRC)) of an access network and a distributed unit (DU) configured to perform functions of lower layers. As an example, the digital unit (DU) 210 may be implemented by being separated into the CU and the DU. Between the core network (e.g., a 5G core (5GC) or a next generation core (NGC)) and a radio network (RAN), the base station may be implemented in a structure in which the CU, the DU, and the RU are disposed in order. An interface between the CU and the distributed unit (DU) may be referred to as an F1 interface.

The centralized unit (CU) may be responsible for functions of higher layers than the DU by being connected to one or more DUs. For example, the CU may be responsible for functions of a radio resource control (RRC) layer and a packet data convergence protocol (PDCP) layer, and the DU and the RU may be responsible for functions of lower layers. The DU may perform a portion of functions (high PHY) of the radio link control (RLC) layer, the media access control (MAC) layer, and the physical (PHY) layer, and the RU may be responsible for remaining functions (low PHY) of the PHY layer. In addition, as an example, the digital unit (DU) may be included in the distributed unit (DU) according to a distributed deployment implementation of the base station. Hereinafter, unless otherwise defined, operations of a digital unit (DU) and an RU are described, but various embodiments of the present disclosure may be applied to both a base station deployment including the CU or a deployment in which the DU is directly connected to the core network (i.e., the CU and the DU are implemented by being integrated into a base station (e.g., an NG-RAN node) that is one entity).

A housing means an exterior that accommodates internal parts in various devices, such as an electronic device, a mechanical device, and the like. The housing is used to protect and fix components of a device. In a case of an electronic device using power, such as network equipment, or a mechanical device physically moving, heat may be generated during an operation. Since heat may adversely affect an operation of the device, the housing is generally designed to have a structure for dissipating heat to the outside. Recently, with development of an electronic industry, electronic parts are being installed more closely to each other on a printed circuit board due to high integration of circuitry and miniaturization of equipment. In addition, according to a trend of miniaturization of electronic devices, high density and high mounting of a package including a printed circuit board, which is a core element thereof, are emerging as important factors. In a case that the electronic device is driven, heat may be generated from each of electronic parts on the printed circuit board. In a case that heat generated from the electronic parts on the printed circuit board is not appropriately dissipated to the outside, since a function is degraded by heat, there is a problem that a lifespan of a product is shortened. Accordingly, in order to maintain optimized performance for an electronic part mounted on the printed circuit board, it is required to maintain an environment suitable for use characteristics of each electronic part used in a device. A device for dispersing and dissipating heat generated inside the device is inevitably required.

Network communication equipment, such as the base station 110, the terminal 120, a RAN intelligence controller (RIC), a central unit (CU), a DU, an RU, a massive multiple input multiple output (MIMO) unit (MMU), or an access unit (AU), may include a plurality of electronic parts for generating a transmission signal to an external electronic device or processing a reception signal from an external electronic device. While the network communication equipment operates, at least one electronic part may generate heat. The network communication equipment may have a heat dissipation structure to disperse generated heat or dissipate the heat to the outside. Hereinafter, in the present disclosure, a structure and related technologies for a heat dissipation structure for dispersing heat generated in the network communication equipment, such as the CU, the DU, the RU, the MMU, and the AU, will be described. Hereinafter, the network communication equipment may be referred to as an electronic device.

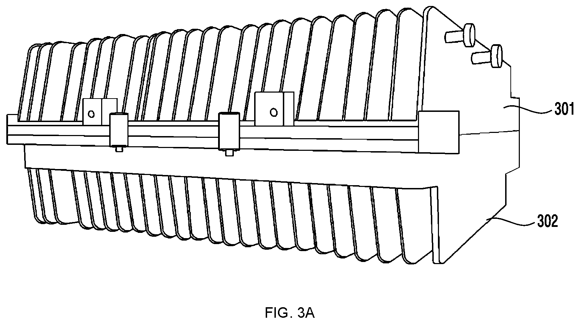

FIG. 3A illustrates an example of an exterior of an electronic device (e.g., a base station 110, a terminal 120, a DU 210, an RU 220, an MMU, or an AU) including a heat dissipation structure.

Referring to FIG. 3A, the electronic device may include a first housing 301 and a second housing 302. The first housing 301 may be referred to as an upper housing, and the second housing 302 may be referred to as a lower housing. The first housing 301 and the second housing 302 may be assembled to form a sealed space for protecting a printed board assembly (PBA) from the outside. The PBA is an assembly of circuitry including a board and a plurality of parts installed on the board. Like the PBA, a component disposed in an internal space formed by the first housing 301 and the second housing 302 may generate heat according to an operation. For example, the operation may include a transmission signal and/or a reception signal for wireless communication, and a data calculation. According to an embodiment, each of the first housing 301 and the second housing 302 may include a plurality of fins for heat dissipation.

A housing (e.g., the first housing 301 and/or the second housing 302) of the electronic device may protect a PBA mounted inside the electronic device from an external environment. For example, the inside of the housing contacting with the PBA may have a shape having various heights due to various sizes of electronic parts of the PBA. The outside of the housing may include a plurality of fins to dissipate heat generated in the PBA to the outside (e.g., into the air). Such a fin may be referred to as a heat dissipation fin. In order to effectively discharge heat, a fin may have a plate shape having a wide surface area. Electronic parts in the PBA may contact with a bottom side of the housing. Through this, while an electronic part operates (e.g., while the electronic part processes a wireless signal), heat generated in the electronic part of the PBA may be discharged into the external air through the bottom side of the housing and the heat dissipation fin.

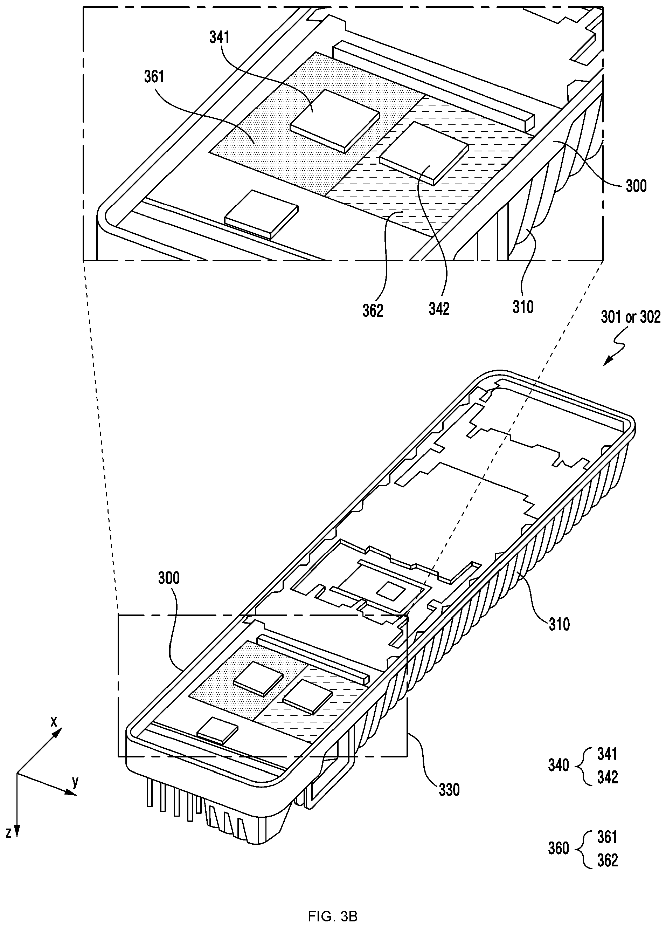

FIG. 3B illustrates an example of an electronic device (e.g., a base station 110, a terminal 120, a DU 210, an RU 220, an MMU, or an AU) including a heat dissipation structure. In FIG. 3B, a cross-section inside a housing (e.g., a first housing 301 and/or a second housing 302) of the electronic device is described.

Referring to FIG. 3B, the electronic device may include a housing 300. A plurality of electronic parts may be disposed inside the housing 300 of the electronic device. The housing 300 of the electronic device may protect a printed circuit board assembly (PBA) mounted inside a product from an external environment. The PBA means a board completed by soldering an electronic part to a printed circuit board (PCB). The PCB is an insulating board on which a conductive pattern (e.g., a pattern configured with a copper wire) is formed for electrical connection of an electronic part, and the PBA may be manufactured through connection between the electronic part and the conductive pattern. The inside of the housing 300 contacting with the PBA may have a shape having various heights due to various part heights on the PBA.

The outside of the housing 300 may include a heat sink 310 to dissipate heat generated in the PBA to the outside. The heat sink 310 of the housing 300 may be formed for heat dissipation. According to an embodiment, the heat sink 310 may include a plurality of fins. Each fin of the plurality of fins may be referred to as a heat dissipation fin. In order to effectively discharge heat, a fin may have a plate shape having a wide surface area. For example, the housing 300 may be manufactured by a diecasting method. The diecasting method is one of casting processes, and not only provides high productivity, but also may provide high precision since a part is manufactured using a mold. The diecasting method includes a method of manufacturing a part using various metals (e.g., aluminum, zinc, magnesium, copper, tin, lead, and iron). For example, the housing 300 may be formed of an aluminum material. Aluminum is light, has high thermal conductivity, and has excellent resistance to corrosion. As network communication equipment becomes highly functional and highly integrated, a demand for weight reduction of the housing 300 also continuously occurs. There are various methods for weight reduction of the housing 300. For example, a technology for reducing weight may be used by using magnesium having a lower specific gravity than aluminum, which is a lightweight metal, or by reducing a fin thickness of the housing 300. For example, in order to diffuse heat of a high heat generation portion to surroundings and dissipate it to the outside, a material having high thermal conductivity may be used in the housing 300 instead of aluminum, or a separate part having high thermal conductivity (e.g., a graphite sheet, a heat pipe, or a vapor chamber) may be attached to the inside of the housing 300.

The housing 300 may reduce an effect in which the PBA or an electronic part is corroded by being exposed to external moisture or dust, and the like. Heat generated in an electronic part may be dissipated to a fin into the external air through an inner side of the housing 300. At least some of parts located on or in the PBA may contact with a side of the housing 300. While the electronic device operates, heat generated in the part(s) may be discharged into the external air through a bottom side of the housing and a heat dissipation fin. Electronic parts disposed on the PBA may have various temperature margins. For a part having high heat generation or a part having an insufficient temperature margin among the electronic parts, a vapor chamber or a heat pipe may be used to widely spread heat generated in the part to a fin of the heat sink 310 of the housing 300 having a wider area for sufficient heat dissipation. Generally, the vapor chamber or the heat pipe may be disposed between the electronic part and the inside of the housing 300. However, since the vapor chamber or the heat pipe uses a copper material having a higher specific gravity than aluminum, the electronic device may become heavier due to an additional heat dissipation part. It may be difficult to mount a large number of heat dissipation parts in the electronic device.

The housing 300 according to embodiments of the present disclosure may have a structure of a vapor chamber inside the housing 300. The vapor chamber, which is a heat conductor using a refrigerant, may be configured to discharge heat through the refrigerant inside a metal plate space. As a space for a working fluid is secured inside the housing 300, the housing 300 may be used not only as a role for protecting a product from the outside but also as a role as a vapor chamber for heat dissipation. For example, an electronic part 340 (e.g., a first electronic part 341 and a second electronic part 342) may contact with a side of the housing 300 through a thermal interface material (TIM). Heat of the electronic part 340 may heat the working fluid of a space inside the housing 300. Through the working fluid, heat of the electronic part 340 may be transferred to an upper side of an internal space. The housing 300 may include a base portion having a support to have an internal space in order to operate as the vapor chamber. The electronic device may include a first base portion 361 for the first electronic part 341. The electronic device may include a second base portion 362 for the second electronic part 342. A space may be formed between a base portion 360 and a cover portion (not illustrated) of the housing 300, and a space may be formed inside heat dissipation fins of the heat sink 310. A working fluid for heat dissipation may be disposed in at least some of the spaces. Through the working fluid, heat of the electronic part 340 may be transferred to heat dissipation fins. Since the heat dissipation fins are exposed to the outside and operate as a cooler, heat of the electronic device may be discharged to the outside. As the housing 300 performs the role of the vapor chamber together, heat generated in the electronic part 340 may be quickly diffused to surroundings.

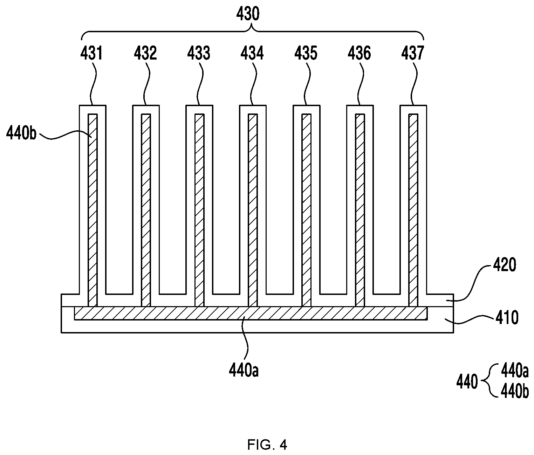

FIG. 4 illustrates a front view of a housing (e.g., a housing 300) having a vapor chamber.

Referring to FIG. 4, the housing 300 may include a base portion 410, a cover portion 420, and a plurality of fin portions 430. The base portion 410 may correspond to a bottom side of the housing 300. The base portion 410 may transfer heat of an electronic part (e.g., an electronic part 340) to the cover portion 420. In order to form a space 440a for a working fluid inside the housing 300, the base portion 410 may include a support. The support may be formed to support the cover portion 420. As the cover portion 420 is disposed on the support of the base portion 410, the space 440a may be formed between the base portion 410 and the cover portion 420. A working fluid (e.g., water) may be disposed in at least a portion of the space 440a. The plurality of fin portions 430 may be disposed on the cover portion 420. For example, the plurality of fin portions 430 may include a first fin portion 431, a second fin 432, a third fin 433, a fourth fin 434, a fifth fin 435, a sixth fin 436, and a seventh fin 437. A space in which a refrigerant may flow may be formed inside each of the plurality of fin portions 430. In other words, each of the plurality of fin portions 430 may not be filled with a metal material, but a separate space 440b that is in a vacuum state or in which an air portion is located may be formed therein. For the space 440b, an end portion of each of the plurality of fin portions 430 may include an opening. At least a portion of the space 440a and the space 440b may contain a working fluid for the vapor chamber. Through the opening, at least a portion of the working fluid may move from the space 440a to the space 440b or from the space 440b to the space 440a.

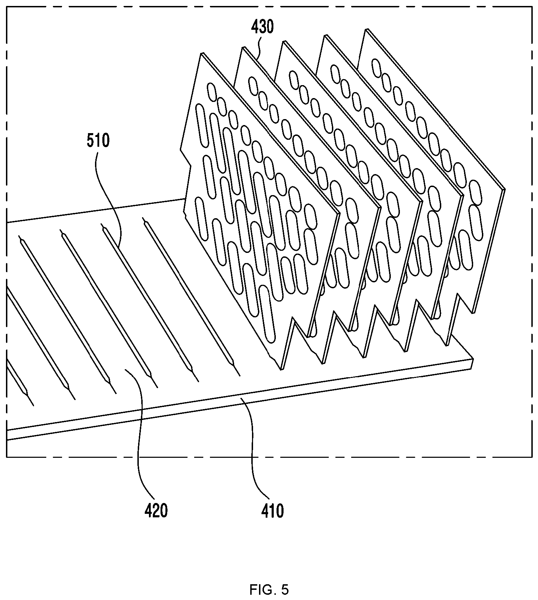

FIG. 5 illustrates a perspective view of a housing (e.g., a housing 300) having a vapor chamber. While a space 440 inside the housing 300 is illustrated in FIG. 4, FIG. 5 is a drawing in which the housing 300 is viewed from the outside.

Referring to FIG. 5, the housing 300 may include a base portion 410, a cover portion 420, and a plurality of fin portions 430. The cover portion 420 of the housing 300 may include a plurality of slots 510. The plurality of slots 510 may respectively correspond to the plurality of fin portions 430. A corresponding fin may be inserted into each of the plurality of slots 510, and a portion of the fin may be soldered while being inserted into the corresponding slot. Through the soldering, the fin may be coupled to the cover portion 420 as a portion of the housing 300.

The housing 300 having the vapor chamber described through FIG. 4 to FIG. 5 may have a space for a working fluid not only between a bottom side of the housing (e.g., a bottom side of the base portion 410) and the cover portion 420, but also inside each fin. Due to the space, thermal resistance between the bottom side and each fin may be eliminated, and heat dissipation may be efficiently possible, and weight reduction and miniaturization of a product may be achieved. In order to implement a vapor chamber of a three-dimensional space, securing a sufficient space 440b inside each fin is required. For injection of the working fluid, a lower end portion of the fin may include an opening. The fin should not only be simply coupled to the cover portion 420, but also should be bonded to the cover portion 420 so that fluid does not leak to the outside. For example, the base portion 410, the cover portion 420, and the plurality of fin portions 430 may be bonded by an aluminum brazing process. Since fluid injected into the housing 300 should not escape to the outside, sealing is required during the bonding. As an example, the cover portion 420 may be configured with an aluminum clad material having different aluminum materials. The aluminum clad material indicates a material configured with aluminum materials having different melting points. Through brazing near the lowest melting point, a melted aluminum material may permeate into a fine gap of a slot by capillary relation, and the cover portion 420 and the plurality of fin portions 430 may be bonded.

When a corresponding fin of the plurality of fin portions 430 is fitted into each of the slots 510 of the cover portion 420, it is required that a sufficient amount of melted aluminum material is supplied so that leakage does not occur in a gap between slots. On the other hand, excessively supplied melted aluminum remaining after filling a gap between each fin and a slot (e.g., the slot 510) of the cover portion 420 may spread to an end of a fin and may be disposed to block an opening of the fin. As openings of a portion of fins among the plurality of fin portions 430 are blocked by an aluminum clad, it may be difficult for a working fluid to flow into interior spaces of the portion of fins. If the working fluid does not enter the interior spaces of the portion of fins, heat dissipation characteristics of the housing 300 may be degraded. In the present disclosure, in order to solve the above-described problem when manufacturing the housing 300 having the vapor chamber, shapes of components of the housing 300 are proposed. Shapes of components of the housing 300 for securing a space (e.g., a space 440a and/or the space 440b) for a working fluid inside the housing 300 and preventing an opening of each fin of the plurality of fin portions 430 of the housing 300 from being blocked due to melted aluminum will be described.

### 1. Shape of an opening of a heat dissipation fin

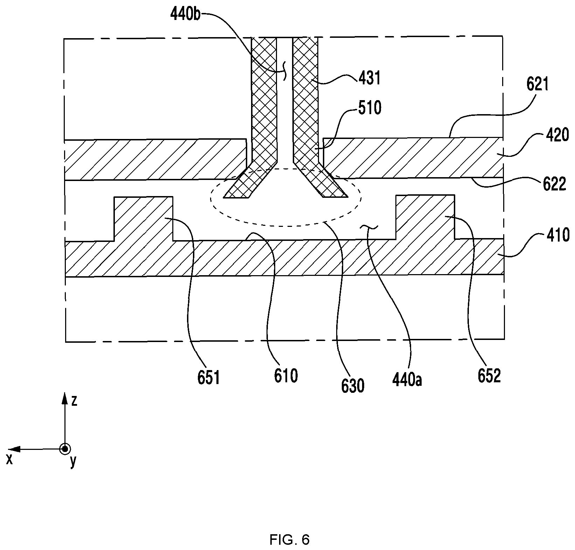

FIG. 6 illustrates an example of components of a housing (e.g., a housing 300) having a vapor chamber. In FIG. 6, for convenience of description, it is described that a (+)y-axis direction is referred to as an upper direction, and a (-)y-axis direction is referred to as a lower direction, but this description is not interpreted as limiting a deployment of the housing 300 or an electronic device including the housing 300.

Referring to FIG. 6, a fin portion 431 may be inserted into a slot 510. A portion of the fin portion 431 may protrude above a first side 621 of a cover portion 420, and another portion (e.g., a portion 630) of the fin portion 431 may protrude below a second side 622 of the cover portion 420. A fluid may be injected into the fin portion 431 of the housing 300 having the vapor chamber. The fin portion 431 may have an opening so that the fluid is injected into the inside of the fin portion 431.

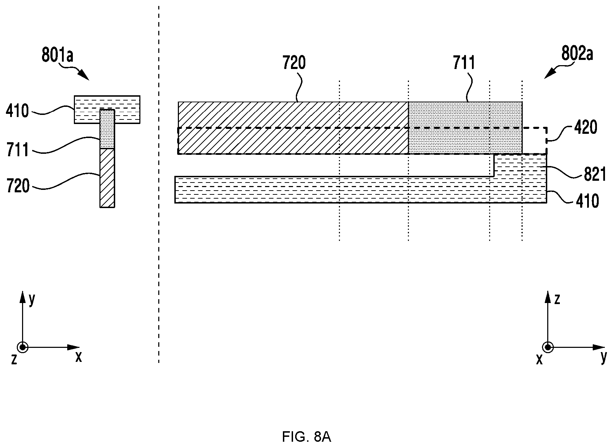

A depth at which the fin portion 431 is inserted into the slot 510 may be determined by various conditions. For a space between a base portion 410 and the cover portion 420, the fin portion 431 should be disposed not to contact with a bottom side 610 of the base portion 410. In addition, as the fin portion 431 is exposed more to the outside, heat dissipation performance may be improved. However, if the fin portion 431 is located only on the first side 621 of the cover portion 420, an opening of a lower end portion of the fin portion 431 may be partially blocked due to melted aluminum. The opening being blocked indicates that a working fluid of the vapor chamber may not smoothly move to an interior space of the fin portion 431, thereby causing degradation of heat dissipation performance. In consideration of the above-described relationships, the fin portion 431 may be disposed to penetrate the slot 510. As an example, a thickness of the cover portion 420 may be about 1.5 mm or more and less than 3.0 mm. The portion 630 of the fin portion 431 may be protruded below the second side 622 of the cover portion 420 by about 0.5 mm or more. The fin portion 431 may include a protruding area so that the portion 630 of the fin portion 431 protrudes by only a specific length and is fixed. A description of the protruding area will be described in detail through FIG. 8A to FIG. 8D.

As described above, the cover portion 420 may be configured with an aluminum clad material having different aluminum materials. For example, the cover portion 420 may be configured with an aluminum clad material having a structure such as "Al40xx/A10xx or Al30xx/Al40xx" or "A10xx or Al30xx/Al40xx". Through an aluminum brazing process, the cover portion 420 may be bonded to the fin portion 431. Through the aluminum brazing process, the cover portion 420 may also be bonded to the base portion 410. While the aluminum brazing process is performed, melted aluminum of the cover portion 420 may fill all of the slot 510 and flow into another gap. At this time, the fin portion 431 may protrude from the second side 622 of the cover portion 420 by a predetermined distance or more so that the melted aluminum does not flow into an opening of the fin portion 431. The portion 630 of the fin portion 431 is exposed in a space 440a. The portion 630 of the fin portion 431 may have a shape in which the opening is expanded through an expansion operation so that inflow of melted aluminum is prevented and an empty space of the slot 510 is filled. For example, through expansion after the fin portion 431 is inserted into the slot 510, the portion 630 of the fin portion 431 may have a shape in which both sides of aluminum sheets contact with the second side 622 of the cover portion 420. For another example, the portion 630 of the fin portion 431 may be inserted into the slot 510 of the cover portion 420 in a state in which an end thereof is widened.

The base portion 410 may include a first pillar portion 651 and a second pillar portion 652. Each pillar portion secures a space for fluid and performs a role of preventing a product from being deformed when a working fluid in a space receives pressure due to temperature when the base portion 410 and the cover portion 420 are bonded.

Although the aluminum brazing process has been described in FIG. 6, embodiments of the present disclosure are not limited thereto. In addition to the aluminum brazing process, various welding methods such as laser, friction stir welding (FSW), and/or a friction stir welding process may be used.

### 2. Protruding areas of a heat dissipation fin

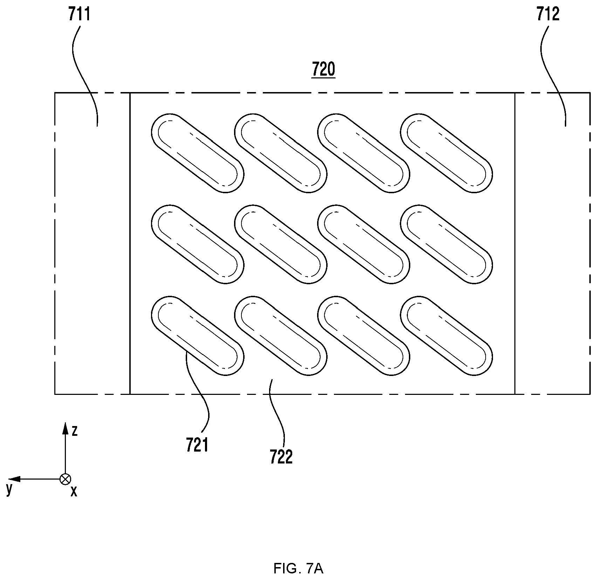

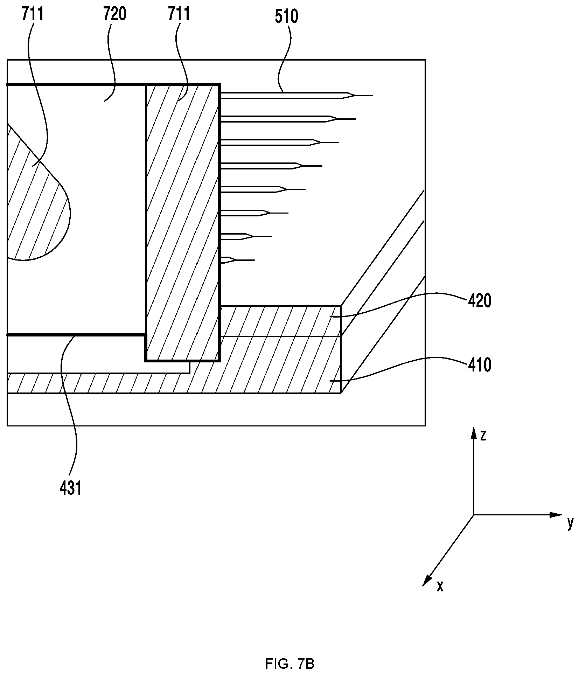

FIG. 7A and FIG. 7B illustrate a connection structure between components of a housing (e.g., a housing 300) having a vapor chamber. In FIG. 7A, a shape of a fin having an interior space for a working fluid is illustrated. In FIG. 7B, a connection structure of a fin portion 431, a base portion 410, and a cover portion 420 is illustrated.

Referring to FIG. 7A, the fin portion 431 may include a heat sink area. The heat sink area may include a first connection area 711, a second connection area 712, and a heat dissipation area 720. The heat sink area may be bonded to the cover portion 420 or a support of the base portion 410 through each of both sides. On a first side of the heat sink area (e.g., an area corresponding to a (+)y-axis direction), the first connection area 711 may be bonded to the cover portion 420 or the support of the base portion 410. On a second side of the heat sink area (e.g., an area corresponding to a (-)y-axis direction), the second connection area 712 may be bonded to the cover portion 420 or the support of the base portion 410. In the first connection area 711, both of two aluminum sheets may be bonded. In the second connection area 712, both of two aluminum sheets may be bonded. The heat dissipation area 720 between the first connection area 711 and the second connection area 712 may include a space in which a working fluid flows. The fin portion 431 may be formed by partially bonding two aluminum sheets (e.g., a first aluminum sheet and a second aluminum sheet). A portion of the two aluminum sheets may be bonded, and another portion may not be bonded. The heat dissipation area 720 may include a bonded area 721 and a non-bonded area 722. If the two aluminum sheets are not bonded, a space in which a working fluid may flow may be formed inside the two aluminum sheets. The non-bonded area 722 may have a shape inflated through air blow. Through a space of the non-bonded area 722, a working fluid for the vapor chamber may flow. In other words, a path through which the working fluid flows may be formed on a space corresponding to the non-bonded area 722.

Referring to FIG. 7B, the fin portion 431 may be coupled to the base portion 410 and the cover portion 420. The first connection area 711 of the fin portion 431 may be inserted into a slot corresponding to the fin portion 431 and may contact with an area of the base portion 410. A protruding portion (or may be referred to as a protruding area) of a lower end of the first connection area 711 corresponding to a lower end of the fin portion 431 causes the heat dissipation area 720 of the fin portion 431 to be spaced apart from the base portion 410 by a predetermined distance. A predetermined space between the base portion 410 and the cover portion 420 may be maintained through the protruding portion of the first connection area 711. However, if the first connection area 711 penetrating the slot and the cover portion 420 are bonded, a possibility that melted aluminum of the cover portion 420 flows beyond the first connection area 711 into the non-bonded area 722 still exists.

In the present disclosure, in order to solve a problem in which a lower portion of the fin portion 431 is blocked, a shape of the fin portion 431 and a structure in which the fin portion 431 is fastened to the base portion 410 or the cover portion 420 are described. When the fin portion 431 is inserted into a slot 510 of the cover portion 420, the fin portion 431 may be disposed such that a lower end portion (e.g., the non-bonded area 722) of the fin portion 431 maintains a predetermined height from a bottom side 610 of the base portion 410. The fin portion 431 may include protruding areas such that the fin portion 431 penetrates the slot 510 and spans the cover portion 420 while having the predetermined height from the bottom side 610 of the base portion 410. Hereinafter, a description of the protruding areas will be described in detail through FIG. 8A to FIG. 8D.

FIG. 8A to FIG. 8D illustrate examples of deployments of a protruding area of a housing (e.g., a housing 300) for separating a cover portion (e.g., a cover portion 420) and a base portion (e.g., a base portion 410) of the housing.

Referring to FIG. 8A, a plan view 801a is a drawing in which a connection structure of a fin portion 431 and the base portion 410 is viewed from above (e.g., viewed in a (-)z-axis direction). A front view 802a is a drawing in which the connection structure of the fin portion 431 and the base portion 410 is viewed from the front (e.g., viewed in a (-)x-axis direction). Both end portions of a heat sink area may have a straight line shape. The fin portion 431 may be disposed such that each of a first connection area 711 and a second connection area 712 spans a support of the base portion 410. For example, the first connection area 711 of the fin portion 431 may be coupled to a support 821 of the base portion 410. However, since the fin portion 431 is inserted by a thickness of the cover portion 410, it is difficult for the fin portion 431 to have a portion protruding to a second side 622 of the cover portion 410. Since there is no protruding portion, the expansion described in FIG. 6 is difficult. Accordingly, the structure of FIG. 8A may cause molten aluminum of the cover portion 420 to block an opening of a heat dissipation area 720.

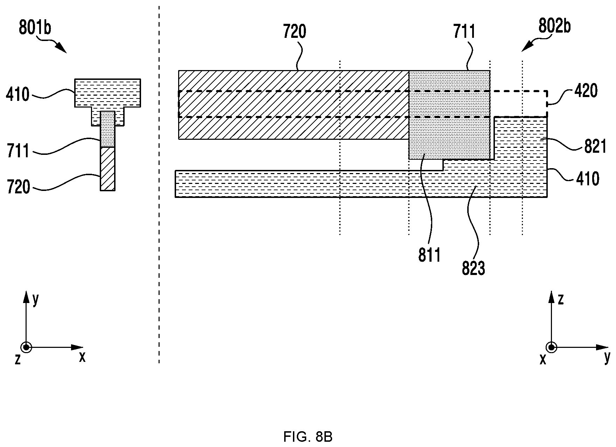

Referring to FIG. 8B, a plan view 801b is a drawing in which a connection structure of the fin portion 431 and the base portion 410 is viewed from above (e.g., viewed in a (-)z-axis direction). A front view 802b is a drawing in which the connection structure of the fin portion 431 and the base portion 410 is viewed from the front (e.g., viewed in a (-)x-axis direction). Both end portions of a heat sink area may include protruding portions. The fin portion 431 may have a shape in which each of the first connection area 711 and the second connection area 712 protrudes. For example, the first connection area 711 of the fin portion 431 may have a protruding portion 811 protruding in the (-)z-axis direction. The protruding portion 811 of the first connection area 711 may function as a stopper. The base portion 410 may have a shape of the support 821 and a step portion 823. The step portion 823 may contact with the protruding portion 811. Through the protruding portion 811, the heat dissipation area 720 of the fin portion 431 may be spaced apart from the base portion 410 by a predetermined distance or more. Since a portion of the fin portion 431 protrudes below the second side 622 of the cover portion 420, the fin portion 431 may have the expanded shape described in FIG. 6. However, based on a y-axis direction, due to bonding between the first connection area 711 and a slot of the cover portion 420, a risk exists that molten aluminum flows into the heat dissipation area 720 of the fin portion 431.

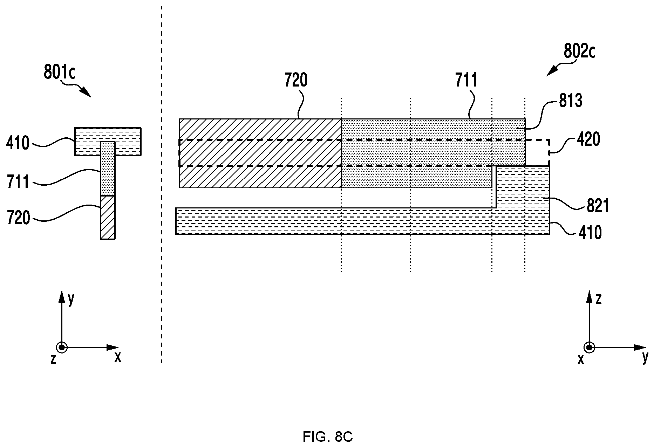

Referring to FIG. 8C, a plan view 801c is a drawing in which a connection structure of the fin portion 431 and the base portion 410 is viewed from above (e.g., viewed in a (-)z-axis direction). A front view 802c is a drawing in which the connection structure of the fin portion 431 and the base portion 410 is viewed from the front (e.g., viewed in a (-)x-axis direction). Both end portions of a heat sink area may include protruding portions. Unlike FIG. 8B, the protruding portions may protrude on an xy plane. The fin portion 431 may have a shape in which each of the first connection area 711 and the second connection area 712 protrudes on the xy plane. For example, the first connection area 711 of the fin portion 431 may have a protruding portion 813 protruding in a (+)y-axis direction. The protruding portion 813 of the first connection area 711 may function as a stopper. The base portion 410 may have a shape of the support 821. The protruding portion 813 may be coupled to the support 821 of the base portion 410. The protruding portion 813 may span over one side of the support 821 of the base portion 410. As the protruding portion 813 is caught on one side of the support 821 of the base portion 410, the heat dissipation area 720 may be spaced apart from a bottom side of the base portion 410 by a predetermined distance or more. In addition, due to the protruding portion 813, a distance of the first connection area 711 in a y-axis direction may be formed to be longer than a distance of the first connection area 711 of FIG. 8A or FIG. 8B. Since a portion of the fin portion 431 protrudes below the second side 622 of the cover portion 420, the fin portion 431 may have the expanded shape described in FIG. 6. The protruding portion 813 may span over an upper side of the support 821, and the first connection area 711 may have a bonding area wider in the y-axis direction than the first connection area 711 of FIG. 8A or FIG. 8B. Due to this shape, molten aluminum from the cover portion 420 when bonding does not block a lower portion of the fin portion 431.

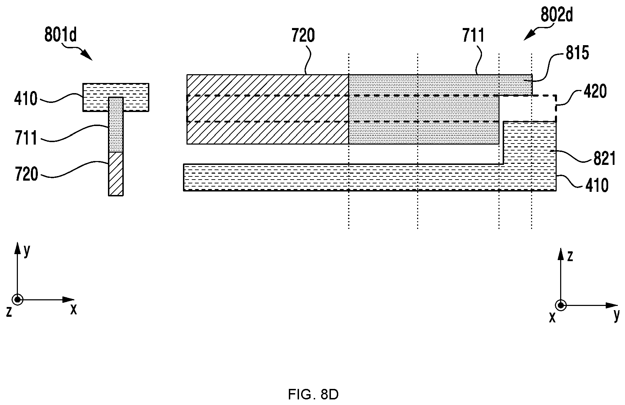

Referring to FIG. 8D, a plan view 801d is a drawing in which a connection structure of the fin portion 431 and the base portion 410 is viewed from above (e.g., viewed in a (-)z-axis direction). A front view 802d is a drawing in which the connection structure of the fin portion 431 and the base portion 410 is viewed from the front (e.g., viewed in a (-)x-axis direction). Both end portions of a heat sink area may include protruding portions. As in FIG. 8C, the protruding portions may protrude on an xy plane. The fin portion 431 may have a shape in which each of the first connection area 711 and the second connection area 712 protrudes on the xy plane. For example, the first connection area 711 of the fin portion 431 may have a protruding portion 815 protruding in a (+)y-axis direction. The protruding portion 815 of the first connection area 711 may function as a stopper. The protruding portion 815 may be coupled to the cover portion 420 of the base portion 410. Unlike FIG. 8C, the protruding portion 815 may not penetrate a slot of the cover portion 420. Accordingly, the protruding portion 815 may be disposed on a first side 621 of the cover portion 420. As the protruding portion 815 is caught on the first side 621 of the cover portion 420, the heat dissipation area 720 may be spaced apart from a bottom side of the base portion 410 by a predetermined distance or more. In addition, due to the protruding portion 815, a distance of the first connection area 711 in a y-axis direction may be formed to be longer than a distance of the first connection area 711 of FIG. 8A or FIG. 8B. Since a portion of the fin portion 431 protrudes below the second side 622 of the cover portion 420, the fin portion 431 may have the expanded shape described in FIG. 6. The protruding portion 815 may span over an upper side (e.g., the first side 622) of the cover portion 420, and the first connection area 711 may have a bonding area wider in the y-axis direction than the first connection area 711 of FIG. 8A or FIG. 8B. Due to this shape, molten aluminum from the cover portion 420 when bonding does not block a lower portion of the fin portion 431.

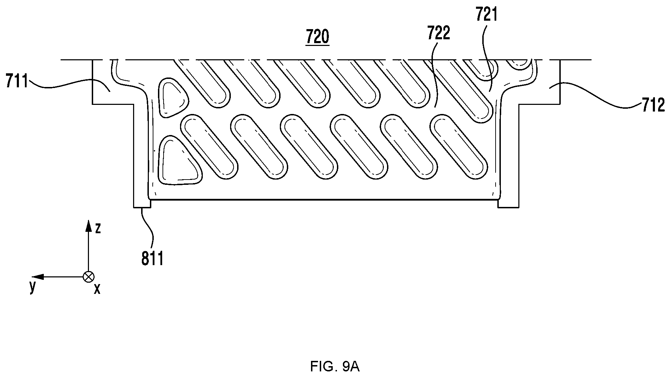

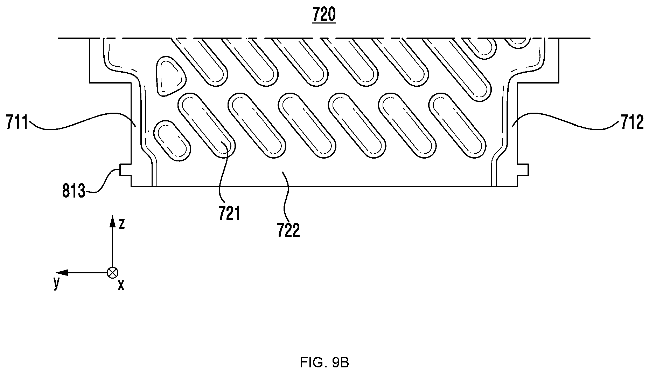

FIG. 9A and FIG. 9B illustrate examples of a fin (e.g., a fin portion 431) of a housing (e.g., a housing 300) having a vapor chamber.

Referring to FIG. 9A, a shape of a heat dissipation fin according to the plan view 802a and the front view 802b of FIG. 8B is illustrated. The fin portion 431 may include a first connection area 711, a second connection area 712, and a heat dissipation area 720. The heat dissipation area 720 may include a bonded area 721 and a non-bonded area 722, and a space inside the non-bonded area 722 may be used as a path of a working fluid for the vapor chamber. A protruding portion 811 may be formed to extend from the first connection area 711 in a (-)z-axis direction, and the heat dissipation area 720 may be spaced apart from a bottom side 610 of a base portion 410 by a predetermined distance or more through the protruding portion 811.

Referring to FIG. 9B, a shape of a heat dissipation fin according to the plan view 802c and the front view 802c of FIG. 8C is illustrated. The fin portion 431 may include the first connection area 711, the second connection area 712, and the heat dissipation area 720. The heat dissipation area 720 may include the bonded area 721 and the non-bonded area 722, and a space inside the non-bonded area 722 may be used as a path of a working fluid for the vapor chamber. The protruding portion 811 may be formed to extend from the first connection area 711 in a (+)y-axis direction, and the heat dissipation area 720 may be spaced apart from the bottom side 610 of the base portion 410 by a predetermined distance or more through the protruding portion 813.

The first connection area 711 of the fin portion 431 of FIG. 9B may extend in a direction (e.g., a (-)y-axis direction) more than the first connection area 711 of the fin portion 431 of FIG. 9A. The second connection area 712 may extend in an opposite direction (e.g., the (+)y-axis direction) to the direction more than the first connection area 711 of the fin portion 431 of FIG. 9A. For example, when referring to a lower end of the fin portion 431, a portion in which the non-bonded area 722 starts after the first connection area 711 in the direction (e.g., the (-)y-axis direction) in FIG. 9B may be located later than a portion in which the non-bonded area 722 starts after the first connection area 711 in the direction (e.g., the (-)y-axis direction) in FIG. 9A. For example, when referring to the lower end of the fin portion 431, a portion in which the non-bonded area 722 starts after the second connection area 712 in the direction (e.g., the (+)y-axis direction) in FIG. 9B may be located later than a portion in which the non-bonded area 722 starts after the second connection area 712 in the direction (e.g., the (+)y-axis direction) in FIG. 9B. In other words, a distance between a support 821 and a lower end portion of the non-bonded area 722 in FIG. 9B may be longer than a distance between the support 821 and a lower end portion of the non-bonded area 722 in FIG. 9B. As a distance from the support 821 to the non-bonded area 722 is increased, a risk that molten aluminum flows into a space inside the non-bonded area 722 may be reduced when processing.

In order to secure a space of the vapor chamber while reducing a risk that an opening is blocked, an area bonded to a slot (e.g., a lower end portion of a boundary between the first connection area 711 and the non-bonded area 722, and a lower end portion of a boundary between the second connection area 712 and the non-bonded area 722) may be formed to be spaced apart from the support 821 more than other areas. For example, the boundary between the first connection area 711 and the non-bonded area 722 may be formed to become farther from the support 821 as the boundary goes downward. The boundary between the second connection area 712 and the non-bonded area 722 may be formed to become farther from the support 821 as the boundary goes downward. According to an embodiment, as the non-bonded area 722 of the heat dissipation area 720 goes downward, a width (e.g., a length in the y-axis direction) thereof may become narrower. As an example, a width of a portion of the non-bonded area 722 located below the protruding portion 813 of each connection area (e.g., the first connection area 711 and/or the second connection area 712) may be narrower than a width of a portion of the non-bonded area 722 located above the protruding portion 813. Among areas of the non-bonded area 722 of the heat dissipation area 720, an area bonded to a slot 510 or a cover portion 420 may be formed far from the support 821.

### 3. Pillars of a base portion

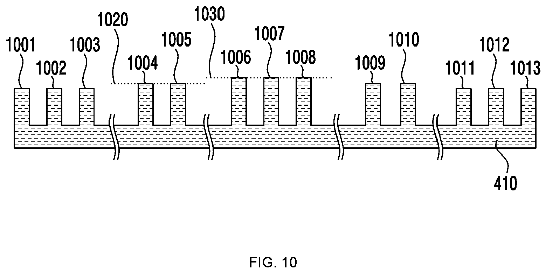

FIG. 10 illustrates an example of a design of pillars of a base portion (e.g., a base portion 410).

Referring to FIG. 10, the base portion 410 may include a plurality of pillar portions (e.g., a first pillar portion 1001, a second pillar portion 1002, a third pillar portion 1003, a fourth pillar portion 1004, a fifth pillar portion 1005, a sixth pillar portion 1006, a seventh pillar portion 1007, an eighth pillar portion 1008, a ninth pillar portion 1009, a tenth pillar portion 1010, an eleventh pillar portion 1011, a twelfth pillar portion 1012, and a thirteenth pillar portion 1013). Each pillar may be referred to as a boss.

A fin portion 431 may be inserted into a slot 510 of a cover portion 420, and a lower end portion (e.g., a portion 630) of the fin portion 431 may be expanded. After an assembly of the fin portion 431 and the cover portion 420 is placed on the base portion 410, a brave process may be performed. A separate jig may be used for bonding quality with the base portion 410, the cover portion 420, and a plurality of fin portions 430. However, as a size of an electronic device becomes larger and an expansion operation for the fin portions 430 increases, flatness (e.g., a degree indicating how flat it is) of the cover portion 420 may deteriorate. Deterioration in the flatness may mean that a side of the cover portion 420 is bent. As the side of the cover portion 420 is bent, at least a portion of pillar portions of the base portion 410 may not be bonded to a second side 622 of the cover portion 420. Due to a pillar portion that is not bonded among the plurality of pillar portions, heat dissipation performance of a vapor chamber of a housing 300 may be degraded.

The housing 300 according to embodiments of the present disclosure may have pillar portions having different heights in order to solve the above-described problem. According to an embodiment, the housing 300 may include pillar portions having different heights according to a location of a pillar portion. Each pillar portion may have a relatively low height as it becomes closer to an outer periphery of the base portion 410, and may have a relatively high height as it becomes closer to a center portion of the base portion 410. As an example, even if the cover portion 420 is bent downward at both end portions, all pillar portions may be bonded to the second side 622 of the cover portion 420 due to height differences of the pillar portions. As a non-limiting example, a maximum height difference between the pillar portions may be designed to be about 0.3 mm or less. For example, pillar heights of pillar portions of a first group (e.g., the first pillar portion 1001, the second pillar portion 1002, the third pillar portion 1003, the eleventh pillar portion 1011, the twelfth pillar portion 1012, and the thirteenth pillar portion 1013) may be different from pillar heights of pillar portions of a second group (e.g., the fourth pillar portion 1004, the fifth pillar portion 1005, the ninth pillar portion 1009, and the tenth pillar portion 1010). A pillar height of the first group and a pillar height of the second group may have a height difference by a first distance 1020 (e.g., about 0.1 mm). The pillar heights of the pillar portions of the second group (e.g., the fourth pillar portion 1004, the fifth pillar portion 1005, the ninth pillar portion 1009, and the tenth pillar portion 1010) may be different from pillar heights of pillar portions of a third group (e.g., the sixth pillar portion 1006, the seventh pillar portion 1007, and the eighth pillar portion 1008). A pillar height of the second group and a pillar height of the third group may have a height difference by a second distance 1030 (e.g., about 0.1 mm).

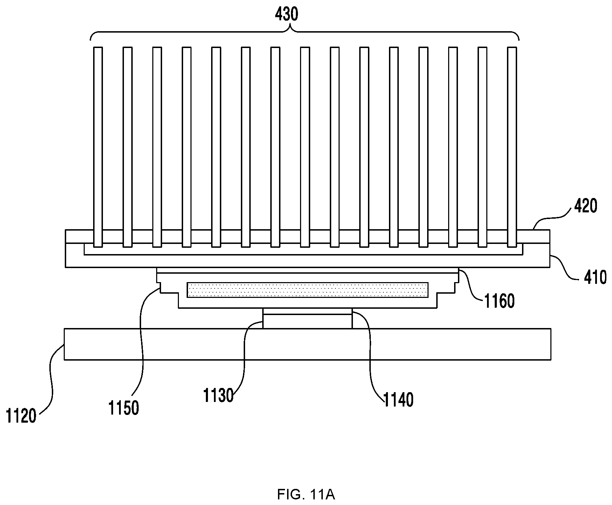

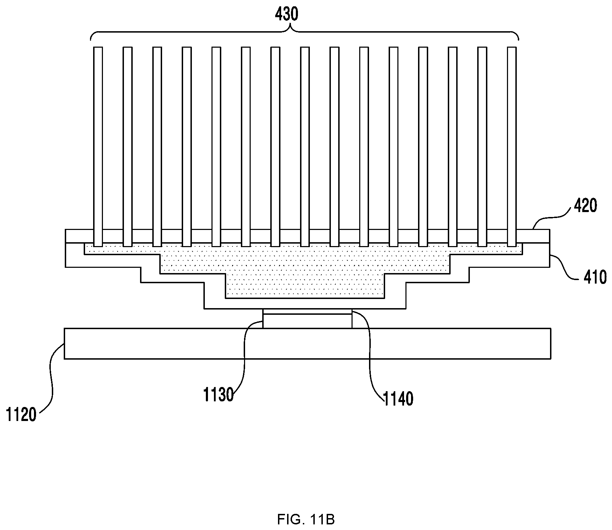

FIG. 11A and FIG. 11B illustrate an example of an electronic device (e.g., a base station 110, a terminal 120, a DU 210, an RU 220, an MMU, or an AU) including a housing having a vapor chamber.

Referring to FIG. 11A, the electronic device may include a housing 300. The housing 300 may include a base portion 410, a cover portion 420, and a plurality of fin portions 430. Due to a brave process, components of the housing 300 may be formed as a molten integral body. The housing 300 may be configured to dissipate heat generated in each electronic part to the outside. Each fin of the plurality of fin portions 430 may be exposed into air due to the electronic device disposed outdoors, and may be configured to cool generated heat.

The electronic device may include a PCB 1120. The PCB 1120 may be coupled to an electronic part configured in a circuitry form and may be configured as a PBA. A plurality of electronic parts may be disposed on one side of the PCB 1120. For example, an electronic part 1130 may be disposed on one side of the PCB 1120. For example, the electronic part 1130 may be a module (e.g., an RFFE, an FEM, an FEMid, a PAMid, or an LPAMid) or a chip including a power amplifier. Heat generated in the electronic part 1130 may be transferred to the housing 300 through a plurality of parts. For example, the electronic device may include a TIM 1140, a vapor chamber 1150, and a TIM 1160. As an example, each of the TIM 1140 and the TIM 1160 may include a thermal pad, a gel, or grease. Since each of the TIM 1140 and the TIM 1160 includes metal and ceramic particles having a thermal conductivity characteristic based on a polymer material, due to a deployment of the TIM 1140 or the TIM 1160, mechanical tolerance may be lowered, and thermal conductivity at an interface may be increased. Heat generated in the electronic part 1130 may be dissipated through the vapor chamber 1150. The heat may contact with the vapor chamber 1150 and may spread to surroundings by an area of the vapor chamber 1150. Heat transferred through the vapor chamber 1150 and the TIM 1160 may be transferred to the plurality of fin portions 430 through the housing 300. However, since the TIM 1140 and the TIM 1160 are added for attachment of the separate vapor chamber 1150, heat dissipation performance may be relatively degraded due to thermal resistance of the TIM. Accordingly, with the deployment structure of FIG. 11A, it is difficult to maximize heat dissipation performance by to the vapor chamber of the housing 300.

Referring to FIG. 11B, the electronic device may include the housing 300. The electronic device may include the PCB 1120. The electronic device may include the electronic part 1130. The electronic device may include the TIM 1140. For each component, the descriptions of FIG. 11A may be referred to. The electronic device of FIG. 11B may include the base portion 410 having an outer shape including a portion adjacent to the electronic part 1130 so that a separate vapor chamber is not required. For example, one side of the base portion 410 may protrude in a direction (e.g., a (-)z-axis direction) to contact with the electronic part 1120 through the TIM 1140. The separate vapor chamber uses copper having high thermal conductivity but having high specific gravity, but since the vapor chamber is omitted in the structure illustrated in FIG. 11B, the structure of FIG. 11B is advantageous for weight reduction. However, heat of the electronic part 1130 is transferred to the cover portion 420 and the plurality of fin portions 430 through a working fluid of an internal space of the housing 300. As the internal space is expanded in a downward direction, thermal resistance may additionally occur. An appropriate amount of working fluid moves while having heat as it is vaporized by heat, but too much fluid remains in a fluid state, and thus may rather act as a thermal resistor.

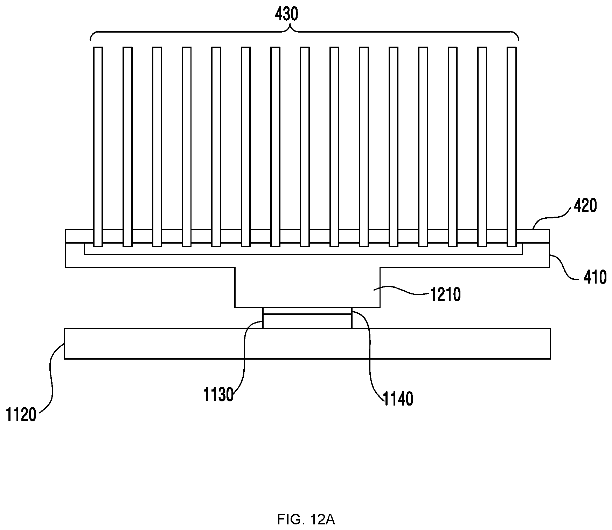

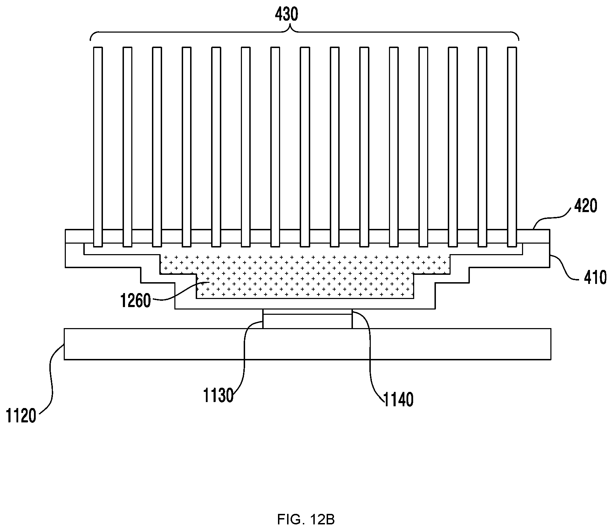

FIG. 12A and FIG. 12B illustrate an example of an electronic device (e.g., a base station 110, a terminal 120, a DU 210, an RU 220, an MMU, or an AU) including a housing having a vapor chamber.

Referring to FIG. 12A, the electronic device may include a housing 300. The electronic device may include a PCB 1120. The electronic device may include an electronic part 1130. The electronic device may include a TIM 1140. For each component, the descriptions of FIG. 11A and FIG. 11B may be referred to. In order to correspond to various heights of the PCB 1120 and the electronic part 1130, a base portion 410 of the housing 300 may have a block portion 1210. The block portion 1210, which is an aluminum portion, may be used to fill a space between a bottom side of the base portion 410 and the electronic part 1130. For example, the block portion 1210 may be manufactured integrally with the base portion 410 or molded together. For another example, the block portion 1210, which is a separate aluminum block, may be bonded to a second side 622 of the base portion 410 during an aluminum brazing process. A size of the block portion 1210 should be larger than a size of the electronic part 1130, which is a heat generation source. As the block portion 1210 is filled with an aluminum material, there is no thermal resistance at an interface, and thus it may provide heat dissipation performance higher than a structure including the vapor chamber 1150 of FIG. 11A.

Referring to FIG. 12B, the electronic device may include the housing 300. The electronic device may include the PCB 1120. The electronic device may include the electronic part 1130. The electronic device may include the TIM 1140. For each component, the descriptions of FIG. 11A and FIG. 11B may be referred to. In order to correspond to various heights of the PCB 1120 and the electronic part 1130, the base portion 410 of the housing 300 may include a porous medium 1260. For example, the porous medium 1260 may be formed by a sintering method of stainless, aluminum, copper, and/or other metal powder. For another example, the porous medium 1260 may be formed through a ceramic powder material.

An appropriate amount of working fluid moves while having heat as it is vaporized by heat, but too much fluid remains in a fluid state, and thus may rather act as a thermal resistor. Fluid is easy to remain near the electronic part 1130. In order to reduce thermal resistance by reducing an amount of fluid, the porous medium 1260 may be disposed in a space of the housing 300. The porous medium 1260 may include fine pores. For example, the porous medium 1260 may include fine pores in units of about several micrometers (um). Due to a hydrophilic and porous material, fluid may be absorbed by the porous medium 1260. The porous medium 1260 may absorb fluid and allow the absorbed fluid to be evenly spread inside the porous medium 1260. Fluid may exist inside the porous medium 1260 and may be easily vaporized by a heat source (e.g., heat of the electronic part 1130).

In embodiments, an electronic device is provided. The electronic device may comprise a printed circuit board, an electronic part disposed on a side of the PCB, and a housing for heat dissipation of the electronic part. The housing may include a base portion for the electronic part, a cover portion disposed on a support of the base portion, and a plurality of fin portions coupled to the cover portion. Each of the plurality of fin portions may have a heat sink area and protruding areas. A portion of the heat sink area may be disposed to protrude from a first side of the cover portion, and another portion of the heat sink area may be disposed to protrude from a second side of the cover portion opposite to the first side. The protruding areas may be coupled to the support or the cover portion such that the heat sink area is disposed to be spaced apart from one side of the base portion by a predetermined distance or more.

For example, at least a portion of a space between the base portion and the cover portion and an interior space of each of the plurality of fin portions may contain a working fluid. The another portion of the heat sink area may include an opening for the interior space.

For example, the another portion of the heat sink area may have a shape in which the opening is expanded in a direction toward the second side.

For example, the cover portion may be formed based on a clad combining a first aluminum material and a second aluminum material having different melting points.

For example, the cover portion may include a plurality of slots. Each of the plurality of fin portions may be disposed to penetrate a corresponding slot among the plurality of slots.

For example, the heat sink area may include a first connection area where a first aluminum sheet and a second aluminum sheet are bonded on a first side, a second connection area where the first aluminum sheet and the second aluminum sheet are bonded on a second side facing opposite to the first side, and a heat dissipation area having an area where the first aluminum sheet and the second aluminum sheet are not bonded as a boundary. In each of the first connection area and the second connection area, a first bonding length corresponding to a first height from one side of the support may be longer than a second bonding length corresponding to a second height higher than the first height from one side of the support.

For example, the base portion may include a plurality of pillars disposed on the one side of the base portion. The plurality of pillars may include a first pillar having a first height and a second pillar having a second height higher than the first height. The second pillar may be disposed closer to a center of the one side of the base portion than the first pillar.

For example, the base portion may include a vapor chamber portion having an internal space through the support, and an aluminum block portion between the vapor chamber portion and the electronic part.

For example, a space between the base portion and the cover portion may include a porous medium disposed on the one side of the base portion.

For example, the electronic device may further comprise a thermal interface material (TIM). The TIM may contact with the electronic part and the base portion.

For example, the electronic part may comprise at least one of at least one processor, a central processing unit (CPU), or a field programmable gate array (FPGA).

For example, the electronic device may comprise a radio unit (RU), a distributed unit (DU), a digital unit (DU), or a massive multiple input multiple output (MIMO) unit (MMU).

In embodiments, a housing having a vapor chamber is provided. The housing may comprise a base portion having a support, a cover portion disposed on the support of the base portion, and a plurality of fin portions coupled to the cover portion. Each of the plurality of fin portions may have a heat sink area and protruding areas. A portion of the heat sink area may be disposed to protrude from a first side of the cover portion, and another portion of the heat sink area may be disposed to protrude from a second side of the cover portion opposite to the first side. The protruding areas may be coupled to the support or the cover portion such that the heat sink area is disposed to be spaced apart from one side of the base portion by a predetermined distance or more.

For example, at least a portion of a space between the base portion and the cover portion and an interior space of each of the plurality of fin portions may contain a working fluid. The another portion of the heat sink area may include an opening for the interior space.

For example, the another portion of the heat sink area may have a shape in which the opening is expanded in a direction toward the second side.

For example, the cover portion may be formed based on a clad combining a first aluminum material and a second aluminum material having different melting points.

For example, the cover portion may include a plurality of slots. Each of the plurality of fin portions may be disposed to penetrate a corresponding slot among the plurality of slots.

For example, the heat sink area may include a first connection area where a first aluminum sheet and a second aluminum sheet are bonded on a first side, a second connection area where the first aluminum sheet and the second aluminum sheet are bonded on a second side facing opposite to the first side, and a heat dissipation area having an area where the first aluminum sheet and the second aluminum sheet are not bonded as a boundary. In each of the first connection area and the second connection area, a first bonding length corresponding to a first height from one side of the support may be longer than a second bonding length corresponding to a second height higher than the first height from one side of the support.

For example, the base portion may include a plurality of pillars disposed on the one side of the base portion. The plurality of pillars may include a first pillar having a first height and a second pillar having a second height higher than the first height. The second pillar may be disposed closer to a center of the one side of the base portion than the first pillar.

For example, a space between the base portion and the cover portion may include a porous medium disposed on the one side of the base portion.

For one or more embodiments, at least one of components described in one or more of the preceding drawings may be configured to perform one or more operations, techniques, processes, and/or methods as described in the present disclosure. For example, a processor (e.g., a baseband processor) described in the present disclosure in association with one or more of the preceding drawings may be configured to operate according to one or more examples described in the present disclosure. For another example, a circuit associated with user equipment (UE), a base station, a network element, or the like, as described above in association with one or more of the preceding drawings, may be configured to operate according to one or more examples described herein.

Any of the embodiments described above may be combined with any other embodiment (or a combination of embodiments) unless explicitly stated otherwise. The foregoing description of one or more implementations is provided for illustration and explanation, but is not intended to limit the scope of the embodiments or to be exhaustive to the precise forms disclosed. Modifications and variations are possible in light of the above teachings or may be obtained from practice of various embodiments.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a nonvolatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. An electronic device comprising:
a printed circuit board (PCB);
an electronic part disposed on a side of the PCB;
a housing for heat dissipation of the electronic part,
wherein the housing includes a base portion for the electronic part, a cover portion disposed on a support of the base portion, and a plurality of fin portions coupled to the cover portion,
wherein each of the plurality of fin portions has a heat sink area and protruding areas,
wherein a portion of the heat sink area is disposed to protrude from a first side of the cover portion and another portion of the heat sink area is disposed to protrude from a second side of the cover portion opposite to the first side, and
wherein the protruding areas are coupled to the support of the base portion or the cover portion such that the heat sink area is disposed to be spaced apart from one side of the base portion by a predetermined distance or more.

2. The electronic device of claim 1,
wherein at least a portion of a space between the base portion and the cover portion and an interior space of each of the plurality of fin portions contains a working fluid, and
wherein the another portion of the heat sink area includes an opening for the interior space.

3. The electronic device of claim 2,
wherein the another portion of the heat sink area has a shape in which the opening is expanded in a direction toward the second side.

4. The electronic device of claim 1,
wherein the cover portion is formed based on a clad combining a first aluminum material and a second aluminum material having different melting points.

5. The electronic device of claim 1,
wherein the cover portion includes a plurality of slots, and
wherein each of the plurality of fin portions is disposed to penetrate a corresponding slot among the plurality of slots.

6. The electronic device of claim 1,
wherein the heat sink area includes a first connection area where a first aluminum sheet and a second aluminum sheet are bonded on a first side, a second connection area where the first aluminum sheet and the second aluminum sheet are bonded on a second side facing opposite to the first side of the heat sink area, and a heat dissipation area having an area where the first aluminum sheet and the second aluminum sheet are not bonded as a boundary, and
wherein, in each of the first connection area and the second connection area, a first bonding length corresponding to a first height from one side of the support is longer than a second bonding length corresponding to a second height higher than the first height from one side of the support.

7. The electronic device of claim 1,
wherein the base portion includes a plurality of pillars disposed on the one side of the base portion,
wherein the plurality of pillars includes a first pillar having a first height and a second pillar having a second height higher than the first height, and
wherein the second pillar is disposed closer to a center of the one side of the base portion than the first pillar.

8. The electronic device of claim 1,
wherein the base portion includes:
a vapor chamber portion having an internal space through the support, and
an aluminum block portion between the vapor chamber portion and the electronic part.

9. The electronic device of claim 1, wherein a space between the base portion and the cover portion includes a porous medium disposed on the one side of the base portion.

10. The electronic device of claim 1, further comprising:
a thermal interface material (TIM),
wherein the TIM contacts with the electronic part and the base portion.

11. The electronic device of claim 1, wherein the electronic part comprises at least one of at least one processor, a central processing unit (CPU), or a field programmable gate array (FPGA).

12. The electronic device of claim 1, wherein the electronic device comprises a radio unit (RU), a distributed unit (DU), a digital unit (DU), or a massive multiple input multiple output (MIMO) unit (MMU).

13. A housing having a vapor chamber, the housing comprising:
a base portion having a support;
a cover portion disposed on the support of the base portion, and
a plurality of fin portions coupled to the cover portion,
wherein each of the plurality of fin portions has a heat sink area and protruding areas,
wherein a portion of the heat sink area is disposed to protrude from a first side of the cover portion and another portion of the heat sink area is disposed to protrude from a second side of the cover portion opposite to the first side, and
wherein the protruding areas are coupled to the support of the base portion or the cover portion such that the heat sink area is disposed to be spaced apart from one side of the base portion by a predetermined distance or more.

14. The housing of claim 13,
wherein at least a portion of a space between the base portion and the cover portion and an interior space of each of the plurality of fin portions contains a working fluid, and
wherein the another portion of the heat sink area includes an opening for the interior space.

15. The housing of claim 14,
wherein the another portion of the heat sink area has a shape in which the opening is expanded in a direction toward the second side.
